# FASCICULE DE BREVET EUROPEEN

(11) **EP 0 668 657 B1**
(45) Date de publication et mention de la délivrance du brevet: **01.07.1998**
(21) Numéro de dépôt: 95400302.6
(22) Date de dépôt: 14.02.1995
(51) Int. Cl.: H03K 17/96

(54) **Dispositif de commande à touche sensitive et clavier de commande à touches sensitives**
Steuerschaltung mit einer berührungsempfindlichen Taste und Tastatur mit berührungsempfindlichen Tasten
Touch sensitive control keyswitch and touch sensitive control keyboard

(30) Priorité: 18.02.1994 FR 9401864
(43) Date de publication de la demande: 23.08.1995
(73) Titulaire: COMPAGNIE EUROPEENNE POUR L'EQUIPEMENT MENAGER "CEPEM", F-45140 St Jean-de-la-Ruelle (FR)
(72) Inventeur: Gouardo, Didier, F-94117 Arcueil Cédex (FR)
(74) Mandataire: Benoit, Monique

(56) Documents cités:
- EP-A- 0 454 523
- US-A- 4 305 135
- US-A- 4 529 967

## Description

La présente invention a pour objets un dispositif de commande à touche sensitive et un clavier de commande à touches sensitives.

Les dispositifs de commande concernés plus particulièrement par l'invention sont du type comportant un circuit électronique à touche sensitive par effet capacitif, alimenté par un générateur de fréquence, le circuit comprenant des moyens de redressement de tension montés en dérivation sur la touche, et des moyens de comparaison de la tension redressée avec une tension de référence continue qui délivrent un signal de sortie à deux états, caractéristiques respectivement de l'activation et de la non-activation de la touche.

Dans les dispositifs connus, le générateur de fréquence comprend un oscillateur et un amplificateur de tension accordé sur le fondamental de l'oscillateur de façon à délivrer au circuit électronique un signal d'entrée Vₑ bien supérieur à la tension d'alimentation du circuit, et augmenter de ce fait la sensibilité de la touche. Par ailleurs, les moyens de comparaison sont généralement constitués soit d'un comparateur recevant sur une première entrée, la tension redressée, et sur une deuxième entrée, la tension de référence continue, soit d'un trigger de Schmitt recevant uniquement la tension redressée, la tension de référence continue étant interne au trigger.

Cependant, dans les deux cas, la tension de référence est une tension continue fixe, ce qui présente un certain nombre d'inconvénients d'après les études de la Demanderesse :

Tout d'abord, le niveau du signal d'entrée Vₑ peut subir des variations dues aux dérives en fréquence de l'oscillateur en fonction de la température, et/ou aux variations de la tension d'alimentation de l'oscillateur et de l'amplificateur, et/ou aux dérives de l'accord de l'amplificateur, l'humidité de l'environnement pouvant modifier la capacité d'accord.

Il en résulte que le niveau du signal d'entrée Vₑ peut être trop fort, de sorte que l'activation de la touche est rendue difficile, ou au contraire trop faible, de sorte que l'activation de la touche s'effectue de façon intempestive.

Par ailleurs, la valeur de la tension de référence peut également subir des variations, soit en raison de la dérive thermique des composants, soit en raison des dispersions de fabrication des composants. Or, cette tension doit être ajustée très précisément et de façon homogène pour toutes les touches d'un même clavier.

EP-A-0 454 523 divulgue un dispositif de commande à touche sensitive selon le préambule de la revendication 1, dans lequel la sortie des moyens de redressement est reliée aux deux entrées des moyens de comparaison, d'une part par une première liaison directe, d'autre part par une seconde liaison comportant un condensateur de stockage.

La présente invention a pour but de pallier les inconvénients précités.

Plus précisément, la présente invention a pour objet un dispositif de commande à touche sensitive tel que défini dans les revendications 1 à 8.

L'invention a également pour objet un clavier de commande tel que défini dans la revendication 9.

L'invention ainsi que ses avantages seront mieux compris au vu de la description suivante, faite en référence aux figures annexées :
- La figure 1 illustre un exemple de réalisation possible d'un dispositif de commande à touche sensitive conforme à l'invention ;
- La figure 2 représente un exemple de réalisation d'un clavier de commande selon l'invention.

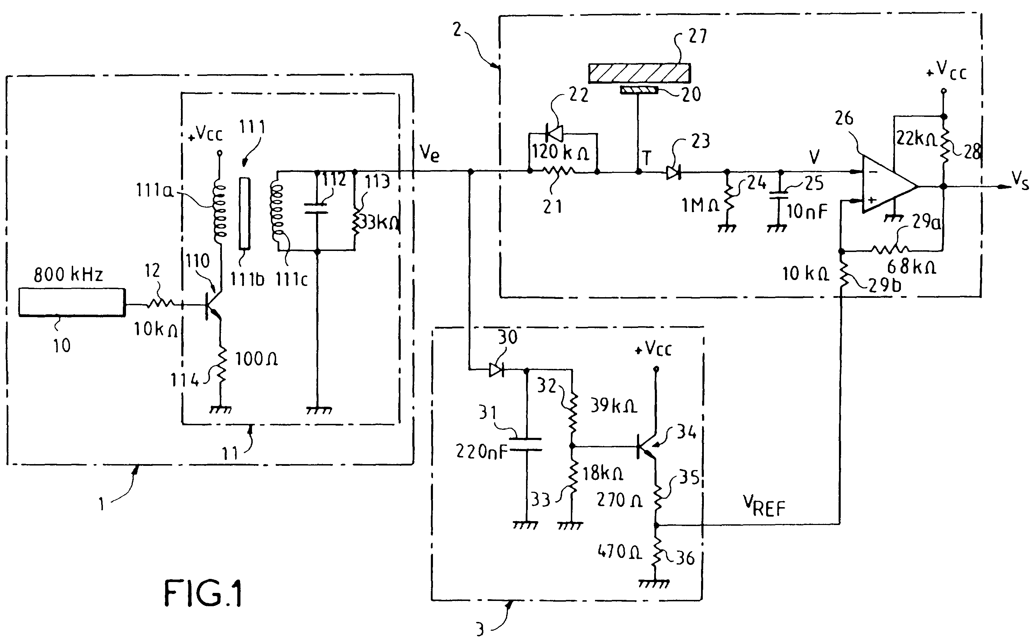

Sur la figure 1, le générateur de fréquence 1 représenté comprend un oscillateur 10 délivrant un signal de quelques centaines de KHz, par exemple 800 KHz, et un amplificateur de tension 11 relié à la sortie de l'oscillateur 10 par l'intermédiaire d'une résistance de liaison 12. L'amplificateur de tension 11 comprend un transistor 110, un transformateur élévateur 111 ainsi qu'un condensateur 112 et une résistance d'amortissement 113 en parallèle avec le secondaire 111c du transformateur. Plus précisément, la base du transistor 110 est reliée à une extrémité de la résistance de liaison 12, l'émetteur est relié à la masse par l'intermédiaire d'une résistance d'émetteur 114, et le collecteur est relié à une première extrémité du primaire 111a du transformateur, la seconde extrémité du primaire étant à un potentiel d'alimentation +V_{cc}. L'amplificateur de tension 11 est accordé sur le fondamental de l'oscillateur 10, l'accord à la résonance du secondaire 111c et du condensateur 112

étant par exemple obtenu en déplaçant un noyau mobile 111b du transformateur. Le signal sinusoïdal Vₑ ainsi généré est appliqué à l'entrée du circuit 2 à touche sensitive. La touche 20 est reliée, au niveau du point T, d'une part à une résistance de liaison 21 en parallèle avec une diode anti-retour 22 et recevant le signal Vₑ, et d'autre part aux moyens de redressement constitués ici d'une diode 23 suivie d'un intégrateur comprenant une résistance 24 en parallèle avec un condensateur 25. Un comparateur 26 compare alors la tension V issue de l'intégrateur avec une tension continue de référence V_{REF}, le résultat de la comparaison étant donné par la tension de sortie Vₛ.

La touche 20, qui est de préférence une plaque de cuivre gravée sur un circuit imprimé, n'est pas directement contactée par un utilisateur, mais est placée sous une couche 27 de verre ou de vitrocéramique, l'ensemble constitué par la touche et la couche de verre se comportant comme un condensateur parasite de capacité Cₚ, ce condensateur étant chargé à travers la résistance 21 lorsque le niveau du signal Vₑ est supérieur au niveau du signal au point T, ou à travers la diode anti-retour 22.

Le fonctionnement d'un tel circuit est le suivant :

Tant que la touche 20 n'est pas activée, la tension redressée V a une valeur supérieure à la tension de référence V_{REF}.

Lorsque la touche 20 est activée, c'est-à-dire lorsque l'utilisateur pose son doigt sur la couche de verre 27 en vis-à-vis de la touche 20, la valeur capacitive Cₚ du condensateur parasite augmente. Le niveau maximal atteint par le signal au point T se trouve alors abaissé, et par suite, la valeur de la tension redressée V devient inférieure à la tension de référence V_{REF}, provoquant un changement d'état du signal Vₛ.

Pour remédier aux problèmes évoqués précédemment et liés aux variations possibles du signal d'entrée Vₑ, le dispositif de commande comporte en outre, conformément à la présente invention, des moyens 3 qui élaborent, à partir du signal d'entrée, une tension continue proportionnelle à la valeur crête du signal d'entrée, cette tension faisant office de tension de référence pour la comparaison avec la tension redressée V. De cette manière, quelles que soient les variations du signal d'entrée Vₑ, la tension de référence V_{REF} reste proportionnelle au signal d'entrée. Tant que la touche 20 n'est pas activée, les deux entrées du comparateur 26 réagissent de la même façon en fonction des variations du signal d'entrée Vₑ. Il n'y a donc aucun risque d'avoir une activation intempestive de la touche due aux variations de Vₑ.

La figure 1 illustre, à titre d'exemple non limitatif, une réalisation possible des moyens 3 :

Ces derniers comprennent des premiers moyens destinés à redresser et à filtrer le signal d'entrée Vₑ, ces premiers moyens étant par exemple constitués d'une diode 30 recevant sur son anode le signal d'entrée Vₑ, et d'un condensateur 31 connecté entre la cathode de la diode 30 et la masse, de manière à filtrer le signal redressé issu de la diode. Des seconds moyens, par exemple constitués par deux résistances 32 et 33 en parallèle sur le condensateur 31 et formant un pont diviseur de tension, permettent de prélever, au niveau du point commun aux deux résistances, une partie du signal redressé et filtré. Cette partie est ensuite appliquée sur la base d'un transistor 34 monté en collecteur commun, et alimenté au niveau du collecteur par une tension d'alimentation +V_{cc}. Avec ce montage, la tension d'émetteur suit donc sensiblement la tension de la base du transistor, à la tension base-émetteur près. Un second pont diviseur, constitué par les deux résistances 35 et 36 reliées en série entre l'émetteur du transistor 34 et la masse, délivre la tension continue V_{REF} servant de référence pour le comparateur.

Préférentiellement, le comparateur 26 est un comparateur à sortie avec collecteur ouvert, chargé par une tension d'alimentation +V_{cc} au travers d'une résistance de charge 28. La sortie du comparateur 26 est réinjectée sur l'entrée positive du comparateur 26 par l'intermédiaire d'une résistance 29a. Par ailleurs, la tension de référence V_{REF} issue des moyens 3 est également appliquée sur l'entrée positive du comparateur par l'intermédiaire d'une résistance 29b. Les deux résistances 29a et 29b permettent au comparateur 26 de fonctionner avec un hystérésis, ce qui renforce par conséquent l'immunité du circuit 2 aux tensions perturbatrices.

Dans le dispositif de la figure 1, tant que la touche 20 n'est pas activée, la tension V sur l'entrée négative du comparateur est à un niveau supérieure au niveau de la tension de référence V_{REF}. La sortie Vₛ du comparateur 26 est alors à une tension proche de 0 Volt. Par contre, dès que la touche 20 est activée, la tension V devient inférieure à la tension de référence V_{REF} , et la sortie Vₛ du comparateur a un niveau proche de la tension d'alimentation +V_{cc} du comparateur.

Des valeurs possibles de différents composants ont été indiquées à titre d'exemple sur la figure 1. Les valeurs des tensions d'alimentation du transformateur du transistor 34 et du comparateur 26 ne sont pas nécessairement identiques.

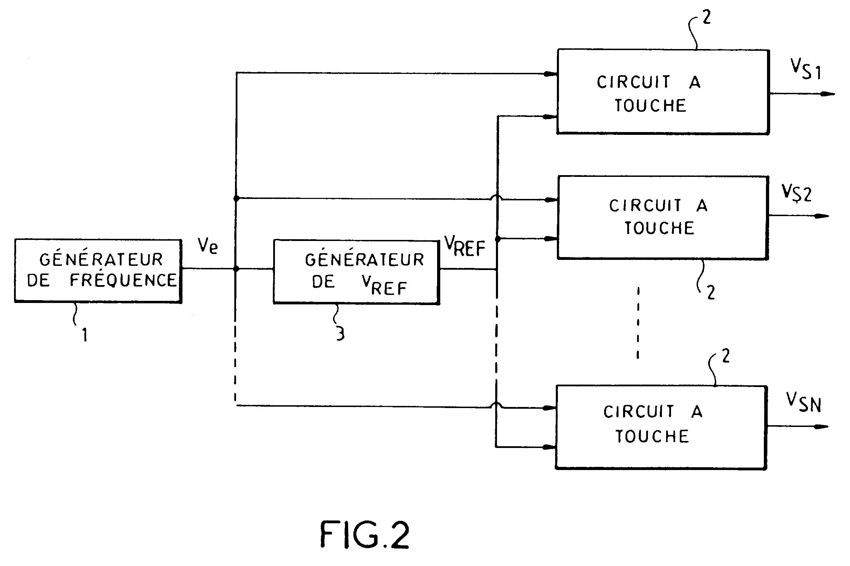

La figure 2 illustre, à titre d'exemple non limitatif, une réalisation possible d'un clavier à N touches sensitives conforme à l'invention.

D'après cette figure, chaque circuit électronique 2 relatif à chaque touche reçoit la tension d'entrée Vₑ et la tension de référence V_{REF} à partir d'un unique générateur de fréquence 1 et d'un unique module 3 de génération de tension de référence. Un tel montage permet une bonne homogénéité dans le fonctionnement des différentes touches.

Différentes variantes de réalisation par rapport au dispositif et au clavier décrits en référence aux figures 1 et 2, peuvent être mises en oeuvre sans sortir du cadre de l'invention :

En particulier, si l'on doit réaliser un clavier comportant peu de touches, typiquement de l'ordre de 2, le transistor 34 et le second pont diviseur 35, 36 ne sont pas nécessaires car le nombre de touches n'est pas susceptible de faire varier la tension de référence. Dans ce cas, la tension de référence V_{REF} est directement prélevée au point milieu des résistances 32, 33 formant le premier pont diviseur.

Une autre variante du montage précédent consiste à remplacer le premier pont diviseur 32, 33 et/ou le second pont diviseur 35, 36, par un potentiomètre, de manière à pouvoir régler la tension de référence, et ajuster la sensibilité générale du dispositif ou du clavier suivant l'environnement (changement d'épaisseur de la couche de verre 27 par exemple). Dans ce cas, une résistance de butée est préférentiellement placée en série entre le potentiomètre et la masse, de manière à éviter tout risque de court-circuit pendant les réglages.

Une autre variante consiste à remplacer le transistor 34 et le second pont diviseur 35, 36, par un amplificateur suiveur. Dans ce cas, le niveau de la tension de référence V_{REF} est ajusté par les valeurs des résistances 32, 33.

D'autre part, si l'on dispose d'un oscillateur qui délivre un signal de niveau suffisant, par exemple de 24 Volts crête à crête, il n'est pas nécessaire d'utiliser l'amplificateur de tension 11. Le signal d'entrée Vₑ est directement le signal issu de l'oscillateur, appliqué à l'entrée du circuit 2 à travers par exemple un condensateur de liaison.

Par ailleurs, la forme du signal d'entrée alternatif est peu importante dans le fonctionnement du dispositif selon l'invention.

Le dispositif et le clavier selon l'invention présentent l'avantage de s'affranchir des problèmes de fonctionnement liés aux variations possibles de la tension d'entrée Vₑ, et de permettre une sensibilité homogène de toutes les touches utilisées dans le clavier.

Par ailleurs, il n'est plus nécessaire d'utiliser, au niveau de l'amplificateur 12, un transformateur 111 à noyau ajustable. En effet, avec le montage selon l'invention, la valeur absolue du signal d'entrée Vₑ n'est plus critique, et le fait d'avoir un amplificateur seulement proche de l'accord sur le fondamental de l'oscillateur 10 peut être toléré sans perturber le fonctionnement du dispositif ou du clavier.

## Revendications

1. Dispositif de commande à touche sensitive du type comportant un circuit électronique (2) alimenté par un générateur de fréquence (1) délivrant au circuit un signal d'entrée analogique (Vₑ), le circuit comprenant une touche sensitive par effet capacitif (20) recevant le signal d'entrée analogique (Vₑ), des moyens (23, 24, 25) de redressement de tension montés en dérivation sur la touche, et des moyens (26) de comparaison de la tension redressée (V) avec une tension de référence continue (V_{REF}), le dispositif étant caractérisé en ce qu'il comporte en outre des moyens (3) qui prélèvent le signal d'entrée (Vₑ) et élaborent une tension continue sensiblement proportionnelle à la valeur crête du signal d'entrée (Vₑ), cette tension continue constituant ladite tension de référence (V_{REF}).

2. Dispositif de commande selon la revendication 1, caractérisé en ce que lesdits moyens (3) comportent des premiers moyens (30, 31) redressant et filtrant le signal d'entrée (Vₑ), et des seconds moyens (32, 33) prélevant une partie du signal redressé et filtré.

3. Dispositif de commande selon la revendication 2, caractérisé en ce que lesdits premiers moyens comportent une diode de redressement (30) recevant sur son anode le signal d'entrée (Vₑ), et un condensateur de filtrage (31) connecté entre la cathode de la diode de redressement et la masse.

4. Dispositif de commande selon l'une quelconque des revendications 2 et 3, caractérisé en ce que les seconds moyens sont constitués par un premier pont diviseur comportant deux résistances (32, 33), la partie du signal redressé et filtré étant prélevée au niveau du point commun des deux résistances.

5. Dispositif de commande selon l'une quelconque des revendications 2 et 3, caractérisé en ce que les seconds moyens sont constitués par un potentiomètre réglable.

6. Dispositif de commande selon l'une quelconque des revendications 2 à 5, caractérisé en ce que la partie du signal redressé et filtré est directement prélevée pour servir de tension de référence.

7. Dispositif de commande selon l'une quelconque des revendications 2 à 5, caractérisé en ce que lesdits moyens (3) comportent en outre un transistor (34) monté en émetteur commun et recevant sur sa base la partie du signal redressé et filtré issue des seconds moyens, et un second pont diviseur constitué par deux résistances (35, 36) reliées en série entre l'émetteur du transistor et la masse, le point commun entre ces deux résistances délivrant la tension de référence (V_{REF}).

8. Dispositif de commande selon l'une quelconque des revendications précédentes, caractérisé en ce que les moyens de comparaison comportent un comparateur à hystérésis.

9. Clavier de commande comportant une pluralité de dispositifs de commande selon l'une quelconque des revendications 1 à 8, caractérisé en ce qu'il comporte un unique générateur de fréquence (1) délivrant à chaque circuit électronique (2) relatif à chaque touche, le signal d'entrée (Vₑ), et en ce que les moyens (3) qui élaborent la tension de référence (V_{REF}) sont communs à tous les dispositifs.

## Patentansprüche

1. Steueranordnung mit berührungsempfindlicher Taste vom Typ mit einer elektronischen Schaltung (2), die von einem Frequenzgenerator (1) gespeist wird, der zu der Schaltung ein analoges Eingangssignal (Vₑ) liefert, wobei die Schaltung eine durch kapazitiven Effekt berührungsempfindliche Taste (20) enthält, die das analoge Eingangssignal (Vₑ) empfängt, Spannungsgleichrichtermitteln (23, 24, 25), die im Nebenschluß an die Taste angeschlossen sind, und mit Mitteln (26) zum Vergleich der gleichgerichteten Spannung (V) mit einer Referenzgleichspannung (V_{REF}), wobei die Anordnung dadurch gekennzeichnet ist, daß sie außerdem Mittel (3) enthält, die das Eingangssignal (Vₑ) abnehmen und eine Gleichspannung erzeugen, die im wesentlichen zu dem Spitzenwert des Eingangssignals (Vₑ) proportional ist, wobei diese Gleichspannung die Referenzspannung (V_{REF}) bildet.

2. Steueranordnung nach Anspruch 1, dadurch gekennzeichnet, daß die Mittel (3) erste Mittel (30, 31) zur Gleichrichtung und Filterung des Eingangssignals (Vₑ) und zweite Mittel (32, 33) zur Abnahme eines Teils des gleichgerichteten und gefilterten Signals enthalten.

3. Steueranordnung nach Anspruch 2, dadurch gekennzeichnet, daß die ersten Mittel eine Gleichrichterdiode (30) enthalten, die an ihrer Anode das Eingangssignal (Vₑ) empfängt, sowie einen Filterkondensator (31), der zwischen der Kathode der Gleichrichterdiode und Masse angeschlossen ist.

4. Steueranordnung nach einem der Ansprüche 2 und 3, dadurch gekennzeichnet, daß die zweiten Mittel durch einen ersten Spannungsteiler mit zwei Widerständen (32, 33) gebildet sind, wobei der Teil des gleichgerichteten und gefilterten Signals an dem Verbindungspunkt der beiden Widerstände abgenommen wird.

5. Steueranordnung nach einem der Ansprüche 2 und 3, dadurch gekennzeichnet, daß die zweiten Mittel durch ein einstellbares Potentiometer gebildet sind.

6. Steueranordnung nach einem der Ansprüche 2 bis 5, dadurch gekennzeichnet, daß der Teil des gleichgerichteten und gefilterten Signals direkt zur Verwendung als Referenzspannung abgenommen wird.

7. Steueranordnung nach einem der Ansprüche 2 bis 5, dadurch gekennzeichnet, daß die Mittel (3) außerdem einen Transistor (34) enthalten, der in Emitterschaltung geschaltet ist und an seiner Basis den von den zweiten Mitteln abgegebenen Teil des gleichgerichteten und gefilterten Signals empfängt, sowie einen zweiten Spannungsteiler, der durch zwei Widerstände (35, 36) gebildet ist, die in Serie zwischen dem Emitter des Transistors und Masse angeschlossen sind, wobei der Verbindungspunkt zwischen diesen beiden Widerständen die Bezugsspannung (V_{REF}) liefert.

8. Steueranordnung nach einem der vorhergehenden Ansprüche, dadurch gekennzeichnet, daß die Vergleichsmittel einen Komparator mit Hysterese enthalten.

9. Steuertastatur mit mehreren Steueranordnungen nach einem der Ansprüche 1 bis 8, dadurch gekennzeichnet, daß sie einen einzigen Frequenzgenerator (1) enthält, der das Eingangssignal (Vₑ) zu jeder einer Taste zugeordneten elektrischen Schaltung (2) liefert, und daß die Mittel (3) zur Bildung der Bezugsspannung (V_{REF}) allen Anordnungen gemeinsam sind.

## Claims

1. Sensitive-key control device of the type including an electronic circuit (2) supplied via a frequency generator (1) delivering an analogue input signal (Vₑ) to the circuit, the circuit comprising a capacitive-effect sensitive key (20) receiving the analogue input signal (Vₑ), voltage rectifying means (23, 24, 25) shunted to the key, and means (26) for comparing the rectified voltage (V) with a DC reference voltage (V_{REF}), the device being characterized in that it furthermore includes means (3) which tap off the input signal (Vₑ) and derive a DC voltage substantially proportional to the peak value of the input signal (Vₑ), this DC voltage constituting the said reference voltage V_{REF}.

2. Control device according to Claim 1, characterized in that the said means (3) include first means (30, 31) rectifying and filtering the input signal (Vₑ), and second means (32, 33) tapping off a part of the rectified and filtered signal.

3. Control device according to Claim 2, characterized in that the said first means include a rectifying diode (30) receiving on its anode the input signal (Vₑ), and a filtering capacitor (31) connected between the cathode of the rectifying diode and earth.

4. Control device according to either one of Claims 2 and 3, characterized in that the second means consist of a first divider bridge including two resistors (32, 33), the part of the rectified and filtered signal being tapped off at the level of the common point of the two resistors.

5. Control device according to either one of Claims 2 and 3 characterized in that the second means consist of an adjustable potentiometer.

6. Control device according to any one of Claims 2 to 5, characterized in that the part of the rectified and filtered signal is tapped off directly so as to serve as reference voltage.

7. Control device according to any one of Claims 2 to 5, characterized in that the said means (3) furthermore include a transistor (34) common-emitter mounted and receiving on its base the part of the rectified and filtered signal from the second means, and a second divider bridge consisting of two resistors (35, 36) linked in series between the emitter of the transistor and earth, the common point between these two resistors delivering the reference voltage (V_{REF}).

8. Control device according to any one of the preceding claims, characterized in that the means of comparison include a hysteresis comparator.

9. Control keyboard including a plurality of control devices according to any one of Claims 1 to 8, characterized in that it includes a single frequency generator (1) delivering the input signal (Vₑ) to each electronic circuit (2) relating to each key, and in that the means (3) which derive the reference voltage (V_{REF}) are common to all the devices.
